# FASCICULE DE BREVET EUROPEEN

(11) **EP 3 452 958 B1**
(45) Date de publication et mention de la délivrance du brevet: **15.01.2025**
(21) Numéro de dépôt: 17725331.7
(22) Date de dépôt: 03.05.2017
(51) Int. Cl.: G06K 19/077

(54) **PROCÉDÉ DE FABRICATION DE CARTES À PUCE ET CARTE À PUCE OBTENUE PAR CE PROCÉDÉ**
VERFAHREN ZUR HERSTELLUNG VON CHIPKARTEN UND DURCH BESAGTES VERFAHREN ERHALTENE CHIPKARTE
METHOD FOR MANUFACTURING CHIP CARDS AND CHIP CARD OBTAINED BY SAID METHOD

(30) Priorité: 06.05.2016 FR 1654102
(43) Date de publication de la demande: 13.03.2019
(73) Titulaire: Linxens Holding, 78200 Mantes-la-Jolie (FR)
(72) Inventeur: PROYE, Cyril, 78200 Magnanville (FR); EYMARD, Eric, 43000 Polignac (FR)
(74) Mandataire: INNOV-GROUP
(86) Numéro de dépôt international: PCT/FR2017/051063
(87) Numéro de publication internationale: WO 2017/191414

(56) Documents cités:
- EP-A1- 2 677 476
- EP-A2- 1 093 082
- WO-A1-2006/070140
- WO-A1-2013/189757
- WO-A1-2015/173514
- FR-B1- 2 880 160
- US-A1- 2008 283 615
- US-A1- 2012 248 201

## Description

L'invention concerne le domaine des cartes à puces. Les cartes à puce sont bien connues du public, qui en a de multiples usages : cartes de paiement, cartes SIM pour téléphones portables, cartes de transport, cartes d'identité, etc.

Les cartes à puce comportent des moyens de transmission pour transmettre des données d'une puce électronique (circuit intégré) à un dispositif lecteur de carte (lecture) ou de ce dispositif à la carte (écriture). Ces moyens de transmission peuvent être « à contact », « sans contact » ou bien à double-interface lorsqu'ils combinent les deux précédents moyens. L'invention permet de réaliser en particulier des cartes à puce à double interface. Les cartes à puce à double interface sont appelées « dual » si les modes « avec contact » et « sans contact » sont gérés par une seule puce ou « hybrides » si les modes « avec contact » et « sans contact » sont gérés par deux puces physiquement distinctes.

Les cartes à puce à double interface sont généralement constituées d'un support rigide en matière plastique de type PVC, PVC/ABS, PET ou polycarbonate constituant l'essentiel de la carte, dans lequel sont incorporés un module électronique et une antenne fabriqués séparément. Le module électronique comporte un circuit imprimé généralement flexible muni d'une puce électronique et des plages de contacts électriquement connectées à la puce et affleurant sur le module électronique, en surface du support constitutif de la carte, pour une connexion par contact électrique avec un dispositif lecteur de carte. Les cartes à puce à double interface comportent en outre au moins une antenne pour transmettre des données entre la puce et un système radiofréquence permettant la lecture ou l'écriture des données, sans contact.

Dans les cartes à puce de type « dual » de l'art antérieur, le module électronique comprenant les contacts et la puce, d'une part, et l'antenne éventuellement intégrée à un support (« inlay » selon la terminologie anglo-saxonne), d'autre part, sont généralement fabriqués séparément, puis l'antenne est connectée au module sur lequel est montée et connectée la puce (un montage de ce type est décrit par exemple dans la demande de brevet WO2013189757A1).

Le document WO2013189757A1 divulgue une méthode pour connecter un module de carte à puce avec un corps de carte comprennant une antenne. U

Le document US 2012/248201 A1 divulgue également une méthode de fabrication d'une carte à puce hybride où les contacts entre l'antenne dans le corps de carte et le module sont réalisés par soudure. U

Le document US 2008/283615A1 divulgue une méthode de fabrication d'une carte à puce hybride utilisant un module, les zones de contacts de l'antenne du corps de carte sont réalisées sous forme de méandres pour augmenter la surface de contact, un matériau de soudure est déposé sur les méandres pour contacter avec les plots de connexion du module. U

Le module et l'antenne peuvent éventuellement bouger légèrement l'un par rapport à l'autre au cours de l'utilisation de la carte, notamment lorsque la carte subit des torsions. De ce fait la connexion entre l'antenne et le module, parfois réalisée par soudure, peut être rompue.

Un but de l'invention est de fiabiliser cette connexion.

Ce but est au moins en partie atteint grâce à un procédé de fabrication d'une carte à puce selon la revendication indépendante 1.

Selon ce procédé on réalise aussi une antenne. L'antenne comporte deux extrémités. Eventuellement, l'antenne est placée sur un support d'antenne. L'antenne est laminée entre des couches de matière plastique. Puis, on met en place le module dans une cavité ménagée dans au moins certaines des couches de matière plastique.

Chacune des extrémités de l'antenne est connectée, à l'aide d'un matériau de soudure déposé sur une portion de connexion, avec un plot de connexion du module. Pour ce faire, on chauffe une fois le module en place dans la cavité, le matériau de soudure déposé sur une portion de connexion.

Pour fiabiliser cette connexion, les plots de connexion sont chacun réalisés sur une zone couvrant une surface inférieure à celle d'une portion de connexion recouverte de matériau de soudure.

En effet, de cette manière, les plots de connexion sont complètement recouverts par le matériau de soudure, notamment après fusion de celui-ci. Ils sont donc pris dans le matériau de soudure après connexion. Ainsi, on optimise la surface des plots de connexion sur laquelle peuvent s'appliquer des contraintes générées lors de déplacements entre le module et le corps de carte et les contraintes sont essentiellement limitées à la zone correspondant à la surface des plots de connexion. Eventuellement, des parties des plots de connexion peuvent se décoller du substrat du module, ce qui leur confère une certaine liberté de mouvement, sans pour autant rompre la connexion entre le module et l'antenne.

Ce procédé comporte également l'une ou l'autre des caractéristiques des revendications 2 à 7 considérées isolément ou en combinaison d'une ou plusieurs autres.

Le procédé selon l'invention peut être mis en oeuvre en continu (« reel-to-reel » selon la terminologie anglo-saxonne).

Selon un autre aspect, l'invention concerne une carte à puce selon la revendication 9.

Selon encore un autre aspect, l'invention concerne un module de carte à puce selon la revendication 11, notamment pour la réalisation d'une carte à puce selon la revendication 9. - Ce module comporte au moins certaines des caractéristiques énoncées dans les revendications 1 à 8 et notamment, il peut comporter un plot de connexion avec au moins une barre s'étendant dans une direction longitudinale sur une longueur comprise entre 1 et 7 mm (préférentiellement, cette longueur est comprise entre 1,5 et 3 mm, par exemple elle est de 2,5 mm), et dont la largeur est comprise entre 50 et 300µm.

Eventuellement, dans ce module de carte à puce, un plot de connexion comporte au moins deux barres dont les extrémités longitudinales sont recourbées et reliées électriquement.

D'autres caractéristiques et avantages de l'invention apparaîtront à la lecture de la description détaillée et des dessins annexés sur lesquels :
- la figure 1 représente schématiquement en perspective une carte à puce conforme à un mode de réalisation selon l'invention :
- la figure 2 représente schématiquement en perspective et de manière éclatée, un exemple d'empilement de couches constitutives de la carte à puce représentée sur la figure 1 ;
- la figure 3 représente schématiquement en perspective et de manière éclatée, une variante du mode de réalisation de la carte à puce représentée sur la figure 2 ;
- la figure 4 représente schématiquement la variante de la carte à puce de la figure 3, après fraisage d'une cavité et avant insertion d'un module selon l'invention dans la cavité ;
- la figure 5 représente schématiquement en perspective différentes étapes d'un procédé de fabrication d'une unité de connexion utilisable dans les modes de réalisation illustrés par les figures 1 à 4 ;
- la figure 6 représente schématiquement en élévation, vu par sa face arrière, un premier mode de réalisation d'un module conforme à l'invention ;
- la figure 7 représente schématiquement la relation entre les surfaces respectives des portions des plages de connexion recouvertes du matériau de soudure, d'une part, et des plots de connexion, d'autre part ;
- la figure 8 représente schématiquement en élévation, vu par sa face arrière, un autre mode de réalisation d'un module conforme à l'invention ; et
- la figure 9 représente schématiquement en coupe une portion d'un plot de connexion en vis-à-vis d'une goutte de matériau de soudure.

Sur les figures, les mêmes références désignent des éléments identiques ou similaires.

Dans ce document les termes « avant », « arrière », « dessus », « dessous », etc. sont purement conventionnels et font, le cas échéant, référence aux orientations telles que représentées sur les figures.

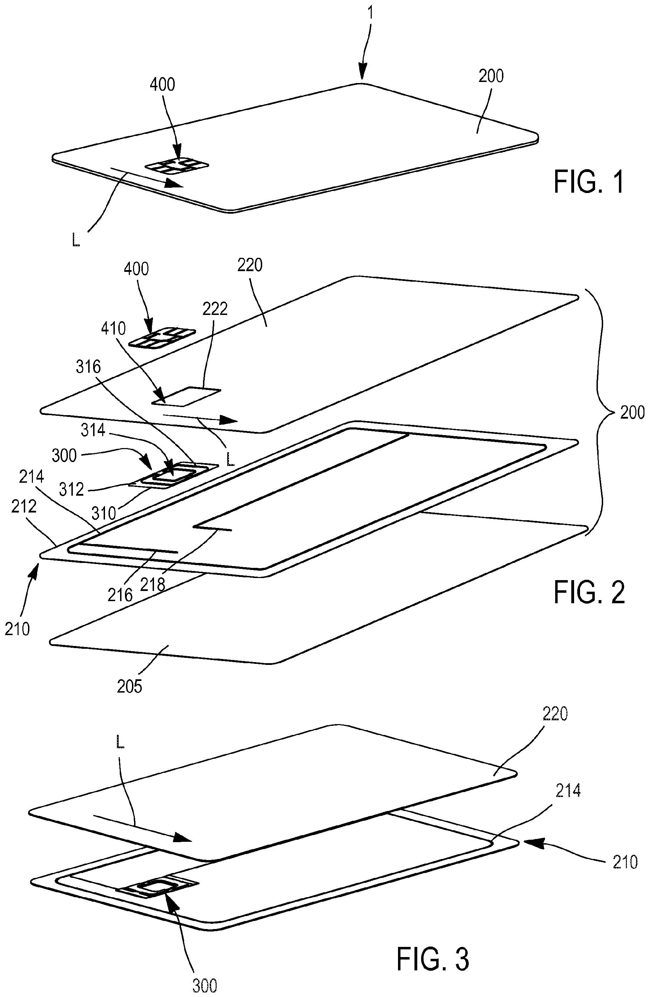

L'exemple de carte à puce 1 représenté sur la figure 1 comporte un corps de carte 200 et un module 400. Une telle carte à puce 1 peut être fabriquée selon plusieurs procédés.

Selon un mode de mise en oeuvre du procédé de fabrication de carte à puce selon l'invention, représenté sur la figure 2, le corps de carte 200 est par exemple constitué d'un complexe multicouche comprenant différentes couches de matière plastique, telles que (de bas en haut sur la figure 2) :
- une couche inférieure 205,
- un support d'antenne 210,
- une unité de connexion 300, et
- une couche supérieure 220.

La couche inférieure 205 est, par exemple, une couche de finition (d'impression par exemple) et de protection de la carte 1. Elle est située sous le support d'antenne 210. Elle est en PVC et son épaisseur est par exemple de 0,20 mm, avant lamination, et de 0,18 mm, après lamination. L'épaisseur de cette couche inférieure 205 est uniforme.

Le support d'antenne 210 comporte un substrat 212 en PVC, par exemple de 0,43 mm d'épaisseur, avant lamination, et de 0,40 mm d'épaisseur, après lamination. Une antenne filaire 214 par exemple est déposée et fixée au substrat 212 (par exemple enchâssée, par la technique dite en anglais du « wire embedding »). Cette antenne 214 est formée de plusieurs spires enroulées et se termine par deux extrémités 216, 218.

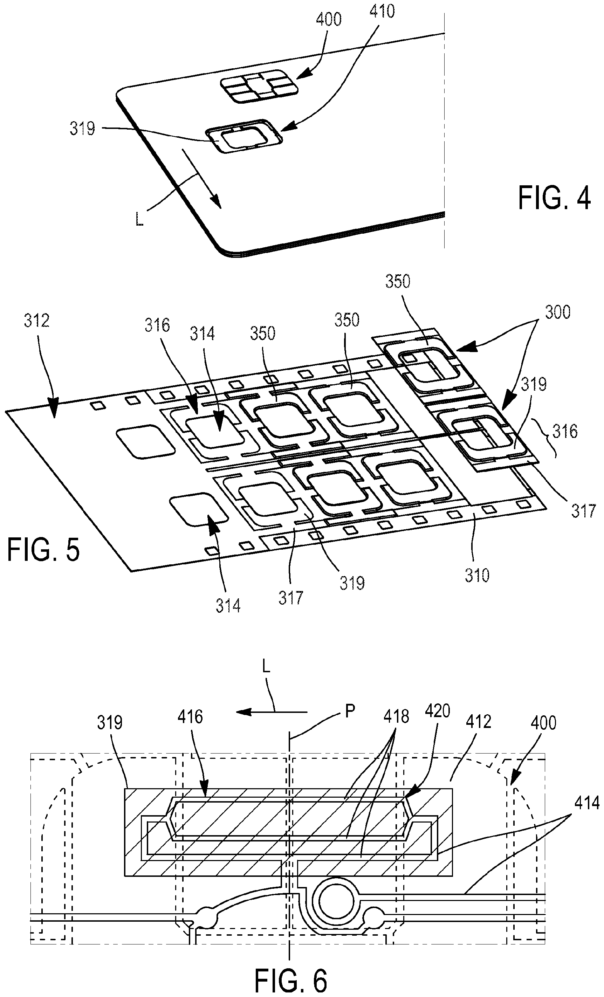

L'unité de connexion 300 comporte un film flexible 310 avec une première et une deuxième faces principales (voir aussi figure 5). Une couche conductrice 312 est colaminée sur l'une de ces faces principales. Le substrat 310 est par exemple constitué d'un matériau de type FR4 ou VEP (verre-epoxy), de 0,075 mm d'épaisseur (et plus généralement inférieure ou égale à 0,1mm). La couche conductrice 312 est par exemple constituée d'un alliage de cuivre en feuillet de 0,03 mm d'épaisseur. Le film flexible 310 est donc par exemple de type stratifié cuivré (« copper clad » selon la terminologie anglo-saxonne).

L'unité de connexion 300 a, par exemple, une longueur de 18 mm et une largeur de 4,5 mm. Une ouverture 314 de 8 mm par 4 mm, par exemple, est découpée sensiblement au milieu de l'unité de connexion 300. L'unité de connexion 300 comporte deux plages de connexion 316. Chaque plage de connexion 316 comporte une première 317 et une deuxième 319 portions, électriquement connectées entre elles (voir également figure 5). La première portion 317 a une forme essentiellement rectangulaire. La deuxième portion 319 a, par exemple, une forme de U s'étendant autour des ouvertures 314, avec le fond du U relié (connecté) essentiellement au milieu de la première portion 317 considérée selon sa direction longitudinale. Selon un autre exemple non-représenté, chaque plage de connexion a une forme en « H » avec chacune des branches parallèle du « H » correspondant respectivement à une première ou une deuxième portion de la zone métallisée, ces première et deuxième portions étant connectées par la branche du milieu.

Comme représenté sur la figure 5, des unités de connexion 300 sont réalisées (par exemple en continu, de bobine à bobine), à partir d'un film flexible 310. Ce film flexible 310 est découpé (par exemple par poinçonnage) pour former les ouvertures 314 destinées à recevoir la résine d'encapsulation d'un module 400, comme expliqué plus loin. Des crans d'entrainement sont également découpés. La couche conductrice est ensuite gravée (par exemple selon des techniques de photolithogravure) pour former les plages de connexion 316 (deux plages de connexion 316 par unité de connexion 300), avec leurs première 317 et deuxième 319 portions.

Du matériau de soudure 350 est ensuite déposé sur chacune des premières 317 et deuxièmes 319 portions des plages de connexion 316, par exemple sur une épaisseur comprise par exemple entre 0,02 à 0,5mm. Le matériau de soudure 350 est par exemple constitué d'un alliage d'étain-bismuth. Le matériau de soudure 350 est ensuite ôté des premières portions 317. Enfin les unités de connexion 300 sont découpées pour être individualisées. Alternativement, le matériau de soudure 350, est déposé de manière plus sélective, par exemple sous forme de goutte de soudure, uniquement sur chacune des deuxièmes portions 319 des plages de connexion 316. Le dépôt du matériau de soudure 350 sur les deuxièmes portions 319 (mais comme indiqué plus haut éventuellement aussi sur les premières portions 317) de la couche conductrice des plages de connexion 316 est réalisé par exemple par dispense, par sérigraphie ou encore par la technologie dite à la « vague » (cette technologie permet de déposer du matériau de soudure 350 sur des épaisseurs de l'ordre de 100 ou 200µm, voire moins, et sur des petites surfaces, comme 3x4 mm² par exemple). Chaque goutte de matériau de soudure 350, une fois déposée sur une deuxième portion 319 et avant l'opération de chauffage pour réaliser la soudure entre l'unité de connexion 300 et le module 400, forme un dôme ayant une hauteur comprise entre 0,02 et 0,5 mm. Chaque goutte de matériau de soudure 350, au cours du chauffage, doit venir au contact des plots de connexion 416 (voir figures 6 à 8). La mouillabilité du matériau de soudure 350 fondu peut éventuellement suffire pour établir la connexion, même dans les cas où une goutte de matériau de soudure 350 ne ferait qu'affleurer à la surface de la cavité 410 sur laquelle le module 400 vient se loger (voir figures 2 et 4). Cependant, on peut éviter un contact insuffisant ou défaillant du fait d'une mouillabilité insuffisante en adaptant la hauteur de chaque goutte de matériau de soudure 350 de manière à ce que cette hauteur soit supérieure à la distance qui sépare le haut de la goutte de matériau de soudure 350 du plot de connexion 416 situé sous le module 400.

Après avoir placé une unité de connexion 300 (éventuellement collée) sur ou dans le support d'antenne 210, les extrémités 216, 218 de l'antenne 214 sont connectées (par exemple par thermocompression) aux premières portions 317 des plages de connexion 316. Cet ensemble, constitué de l'antenne 214 et de l'unité de connexion 300 sur le support 210, peut être recouvert d'une couche matériau plastique pour former une structure qui peut être vendue pour être laminée avec une ou plusieurs autres couches de matériau plastique afin de réaliser une carte à puce 1.

Revenant à la description de l'empilement des couches de matière plastique, en relation avec la figure 2, on notera que le support d'antenne 210 peut être composé d'au moins deux sous-couches. Dans ce cas, l'antenne est insérée par exemple entre la sous-couche du dessous et la sous-couche du dessus. La sous-couche du dessus comporte alors une découpe pour recevoir une unité de connexion 300.

La couche supérieure 220 de finition et de protection est également par exemple en PVC. Elle fait 0,20 mm d'épaisseur avant lamination et 0,18 mm d'épaisseur après lamination. Cette couche supérieure 220 de finition et de protection comporte une découpe 222 correspondant à une cavité 410.

Alternativement, selon la variante illustrée par les figures 3 et 4, plutôt que de réaliser une découpe 222 dans la ou les différentes couches laminées au-dessus du support d'antenne 210, la couche supérieure 220 est laminée avec le support d'antenne 210 (et éventuellement les autres couches constitutives du corps de carte 200) sans que celle-ci ne soit préalablement découpée (figure 3). Puis, la cavité 410 est fraisée pour faire apparaître les deuxièmes portions 319 des plages de connexion avant connexion et fixation du module 400 dans la cavité 410. Avantageusement, lors du fraisage de la cavité 410, une partie de chaque goutte de matériau de soudure 350 est ôtée, pour s'assurer que le matériau plastique dans lequel est réalisé le fraisage n'empêchera, ni ne rapprochement des surfaces à souder, ni le matériau formant les gouttes de matériau de soudure 350 en fusion de mouiller les pistes conductrices du module 400 sur lesquelles elles doivent être soudées. Les premières portions 317 des plages de connexion 316, sur lesquelles ont été connectées les extrémités 216, 218 de l'antenne 214, se trouvent hors de la zone fraisée et restent protégées par la couche supérieure 220.

La couche inférieure 205 et la couche supérieure 220, ainsi que le support d'antenne 210 ne sont pas nécessairement des monocouches. Chacune d'elles peut éventuellement être constituée d'une ou plusieurs couches, toutes laminées ensemble dans la carte 1 finie.

L'épaisseur totale de l'ensemble des couches 205-220, et donc de la carte 1, est sensiblement de 0,8 mm après lamination.

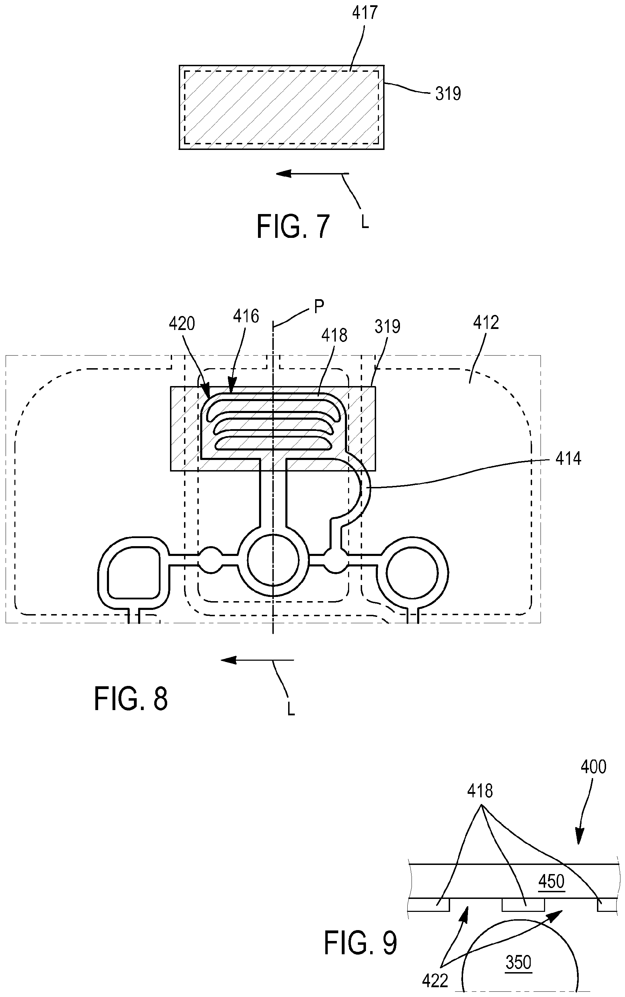

Un module 400, dit « double-face », est réalisé par exemple de manière connue sur un substrat comportant des contacts 412 sur une face (appelée « face contact » ou « face avant »), et des pistes conductrices 414 (ainsi qu'une puce électronique non-représentée), sur l'autre (appelée « face arrière » ou « face bonding ») (voir figures 6 et 8). La fixation de la puce électronique sur le substrat est réalisée par au moins une technique connue telle que le fixage de puce (« die-attach » selon la terminologie anglo-saxonne) et sa connexion électrique aux pistes conductrices 414 est réalisée par au moins une technique connue telle que la technologie de la puce retournée (« flip-chip » selon la technologie anglo-saxonne), la soudure de fils (« wire-bonding » selon la terminologie anglo-saxonne), etc. La puce et ses éventuelles connexions par fils aux pistes conductrices 414 sont avantageusement protégées par encapsulation dans une résine (« globe top » ou « dam&fill » selon la terminologie anglo-saxonne, correspondant à une encapsulation UV ou thermique). La puce étant placée sur la face arrière du substrat ou dans une découpe réalisée dans celui-ci, l'encapsulation est réalisée à partir de cette face arrière et peut former une surépaisseur par rapport à cette celle-ci.

Comme représenté, sur les figures 6 et 7, les pistes conductrices 414 comportent des plots de connexion 416. Ces plots de connexion 416 sont utilisés pour souder les deuxièmes portions 319 des plages de connexion 316. Ainsi, les extrémités 216, 218 de l'antenne 214, sont elles-mêmes électriquement reliées aux premières portions 317, reliées aux deuxièmes portions 319, qui elles-mêmes sont soudés aux plots de connexion 416 reliés électriquement sur la face arrière du module 400 à la puce par les pistes conductrices 414.

Comme illustré schématiquement par la figure 7, chaque plot de connexion 416 s'étend dans une zone 417 (délimitée par des traits pointillés sur la figure 7) couvrant une surface inférieure à celle des deuxièmes portions 319 (sur les figures 6 à 8 les deuxièmes portions 319 sont représentées sous forme d'un rectangle hachuré, mais elles peuvent avoir d'autres formes et notamment celle en « U » représentée sur les figures précédentes). La zone 417 peut être définie comme étant celle qui contient des barres 418 et les pistes conductrices qui relient les barres 418 entre elles. Les barres 418 sont allongées selon une direction L essentiellement perpendiculaire au plus grand côté du module 400, qui est généralement destiné à être parallèle à la longueur de la carte 1. La direction longitudinale L est représentée sur les figures 1 à 4.

Dans le mode de réalisation représenté sur la figure 6 (qui correspond par exemple à un module 400 à huit contacts - dit « 8 pins »), les barres 418 sont au nombre de trois.

Chaque barre 418 est relativement fine de manière à éventuellement pouvoir se désolidariser du substrat du module 400 pour absorber, sans rompre, une contrainte importante. Elle a une largeur l par exemple comprise entre 50µm et 300µm. Plus particulièrement, elle peut avoir une largeur voisine de 100µm. Le fait d'avoir une largeur fine leur permet de se décoller éventuellement du substrat 450 du module 400.

Les barres 418 ont par exemple une longueur comprise entre 1 et 7mm. Les barres 418 représentées sur les figures 6 et 8 sont essentiellement rectilignes, mais elles pourraient être ondulées, sinusoïdales, etc.

De manière à pouvoir absorber les contraintes de manière la plus uniforme possible, les barres 418 sont essentiellement symétriques par rapport à un plan P perpendiculaire au substrat du module 400 et à la direction longitudinale L, et passant par le milieu du module 400.

Les barres 418 se rejoignent à chacune de leurs extrémités longitudinales et sont connectées aux pistes conductrices 414.

Afin de réduire les contraintes susceptibles de s'accumuler aux extrémités des barres 418, les extrémités de celles-ci se terminent par des portions recourbées 420. Les rayons de courbures des portions recourbées permettent de répartir les contraintes sur une plus grande longueur et une plus grande surface.

Dans le mode de réalisation représenté sur la figure 8 (qui correspond par exemple à un module 400 à six contacts - dit « 6 pins »), les barres 418 sont au nombre de trois et les portions recourbées 420 des extrémités longitudinales des barres sont dirigées vers l'intérieur du module. Dans ce mode de réalisation, les deux barres 418 les plus éloignées du centre du module 400 ont par exemple une largeur de 100µm et celle la plus proche du centre a une largeur de 150µm. Leur longueur est préférentiellement comprise entre 1,5 et 3 mm ; par exemple elle est de 2,5 mm.

Pour poursuivre la fabrication de la carte à puce 1, le module 400 est mis en place dans la cavité 410, avec le matériau de soudure 350, disposé sur chacune des deuxièmes portions 319 des plages de connexion 316, en vis-à-vis des plots de connexion 416.

Les zones du module 400 de trouvant au niveau des gouttes de matériau de soudure 350 sont ensuite chauffées, par exemple à l'aide d'une thermode, pour faire fondre le matériau de soudure 350 et souder les plages de connexion 316 aux plots de connexion 416 (Cette opération de chauffage est éventuellement effectuée en même temps que celle consistant à faire chauffer des zones d'adhésif thermo-réactivable, très proches des gouttes de matériau de soudure permettant de coller chaque module dans sa cavité). En choisissant un matériau de soudure 350 ayant une température de fusion comprise entre 120°C et 230°C, et plus préférentiellement entre 130 et 150°C, on peut réaliser l'opération de chauffage du matériau de soudure 350 en appliquant, avec une thermode par exemple, sur une zone du module 400, une température comprise entre 120°C et 250°C.

Du fait de l'épaisseur du module 400 et de la hauteur du dôme d'une goutte de matériau de soudure 350, lorsque le matériau de soudure fond, il vient mouiller le plot de connexion 416 correspondant.

Par ailleurs, comme représenté sur la figure 9, les espaces entre les barres 418 forment des gorges 422, délimitées d'une part par les flancs correspondant à l'épaisseur des barres 418, et d'autre part, par le substrat 450 du module 400. Ces gorges 422 permettent de canaliser le matériau de soudure 350 et d'éviter que celui-ci ne se répande largement hors de la zone 417 dans laquelle s'inscrit un plot de connexion 416.

Eventuellement, la soudure entre les plages de connexion 316 et les plots de connexion 416 peut couvrir une surface au moins de l'ordre de 2mm² et est telle que l'on obtient une force d'arrachement du module 400 suffisamment élevée, pour répondre aux spécifications de ce type de produit. Le matériau de soudure 350 permet ainsi éventuellement, non seulement d'établir une connexion électrique entre les plots de connexion 416 et les plages de connexion 316, mais également de fixer le module 400 dans la cavité 410 sans l'aide d'autre adhésif.

Dans ce qui précède, il a été décrit une structure de carte à puce 1 dans laquelle une unité de connexion est utilisée pour faire la connexion entre l'antenne 214 et le module 400. Mais, l'invention s'applique également à une structure dans laquelle une antenne et des plages de connexion se trouvent sur un même substrat (par exemple l'antenne et les plages de connexion sont gravées sur un même substrat qui forme alors un support d'antenne 210).

## Revendications

1. Procédé de fabrication d'une carte à puce, comprenant :
- la réalisation d'un module (400) de carte à puce (1) comportant un substrat (450) ayant une première et une deuxième faces principales, avec sur la première face du substrat, des contacts (412), et sur la deuxième face du substrat, des pistes conductrices (414) comprenant des plots de connexion (416), ce module étant également muni d'une puce électronique (120) connectée à au moins certains contacts (102) et à au moins deux pistes conductrices (414) dédiées à une connexion d'antenne,
- la réalisation d'une antenne (214) comportant deux extrémités (216, 218),
- la lamination de l'antenne (214) entre des couches de matière plastique (205, 220), et
- la mise en place du module (400) dans une cavité (410) ménagée dans au moins certaines des couches de matière plastique (220),
- la connexion à l'aide d'un matériau de soudure déposé sur une portion de connexion (319) de chacune des extrémités (216, 218) de l'antenne (214) avec un plot de connexion (416) du module (400), et chauffé, une fois le module (400) en place dans la cavité (410),
**caractérisé par le fait que** les plots de connexion (416) sont chacun réalisés sur une zone (417) couvrant une surface inférieure à celle d'une portion de connexion (319), formée dans une couche conductrice et recouverte de matériau de soudure (350).

2. Procédé selon la revendication 1, dans lequel le matériau de soudure (350) est constitué d'un matériau ayant une température de fusion comprise entre 120°C et 230°C, et plus préférentiellement entre 130°C et 150°C.

3. Procédé selon l'une des revendications précédentes, dans lequel on réalise au moins l'un des plots de connexion (416) comportant au moins une barre (418) s'étendant longitudinalement dans une direction (L) sur une longueur comprise entre 1 et 7 mm.

4. Procédé selon l'une des revendications précédentes, dans lequel on réalise au moins l'un des plots de connexion (416) comportant au moins une barre (418) dont la largeur est comprise entre 50 et 300µm.

5. Procédé selon l'une des revendications précédentes, dans lequel on réalise au moins l'un des plots de connexion (416) comportant au moins une barre (418) s'étendant longitudinalement dans une direction (L) essentiellement perpendiculaire à la longueur du module (400).

6. Procédé selon l'une des revendications précédentes, dans lequel on réalise au moins l'un des plots de connexion (416) comportant au moins une barre (418) dont les extrémités sont recourbées vers l'intérieur du module (400).

7. Procédé selon l'une des revendications précédentes, dans lequel on réalise au moins l'un des plots de connexion (416) comportant au moins deux barres (418) reliées électriquement par leurs extrémités longitudinales.

8. Procédé selon l'une des revendications précédentes, dans lequel on réalise une unité de connexion (300) et on connecte les extrémités de l'antenne (214) d'une part à des premières portions (317) de l'unité de connexion (300) et d'autre part on dépose une goutte de matériau de soudure (350) sur des deuxièmes portions (319) de l'unité de connexion (300) pour réaliser une soudure avec chacun des plots de connexion (416).

9. Carte à puce comprenant :
- une antenne (214) comportant deux extrémités (216, 218),
- des couches de matière plastique (205, 220) entre lesquelles est placée l'antenne (214), et
- un module (400) comportant un substrat (450) ayant une première et une deuxième faces principales, avec sur la première face du substrat, des contacts (412), et sur la deuxième face du substrat, des pistes conductrices (414) comprenant des plots de connexion (416), ce module étant également muni d'une puce électronique connectée à au moins certains contacts (412) et à au moins deux pistes conductrices (414) dédiées à une connexion d'antenne, le module (400) étant placé dans une cavité (410) ménagée dans au moins certaines des couches de matière plastique (220),
- une portion de connexion (319), reliée à chacune des extrémités (216, 218) de l'antenne (214) et comportant du matériau de soudure soudé à un plot de connexion (416) du module (400),
**caractérisée par le fait que** les plots de connexion (416) couvrent chacun une zone (417) ayant une surface inférieure à celle d'une portion de connexion (319), formée dans une couche conductrice et recouverte du matériau de soudure (350).

10. Carte à puce selon la revendication 9, dans laquelle le matériau de soudure (350) est constitué d'un matériau ayant une température de fusion comprise entre 120°C et 230°C, et plus préférentiellement entre 130°C et 150°C.

11. Module de carte à puce pour la réalisation d'une carte à puce selon l'une des revendications 9 et 10, ce module comportant un substrat (450) ayant une première et une deuxième faces principales, avec sur la première face du substrat, des contacts (412), et sur la deuxième face du substrat, des pistes conductrices (414) comprenant des plots de connexion (416), ce module étant destiné à être muni d'une puce électronique connectée à au moins certains contacts (412) et à au moins deux pistes conductrices (414) dédiées à une connexion d'antenne, ce module étant également destiné à être connecté à une portion de connexion (319), formée dans une couche conductrice et reliée à chacune des extrémités (216, 218) d'une l'antenne (214) et comportant du matériau de soudure,
dans lequel les plots de connexion (416) couvrent chacun une zone (417) ayant une surface inférieure à celle d'une portion de connexion (319) recouverte du matériau de soudure (350) et au moins l'un des plots de connexion (416) comporte au moins une barre (418) s'étendant longitudinalement dans une direction (L) sur une longueur comprise entre 1 et 7 mm et dont la largeur est comprise entre 50 et 300µm.

12. Module de carte à puce selon la revendication 11, dans lequel le matériau de soudure (350) est constitué d'un matériau ayant une température de fusion comprise entre 120°C et 230°C, et plus préférentiellement entre 130°C et 150°C.

13. Module de carte à puce selon l'une des revendications 11 ou 12, dans lequel un plot de connexion (416) comporte au moins deux barres (418) dont les extrémités longitudinales sont recourbées et reliées électriquement.

## Patentansprüche

1. Verfahren zur Herstellung einer Smartcard, umfassend :
- Herstellung eines Moduls (400) einer Chipkarte (1) mit einem Substrat (450) mit einer ersten und einer zweiten Hauptseite, mit Kontakten (412) auf der ersten Seite des Substrats und Leiterbahnen (414) mit Anschlussflächen (416) auf der zweiten Seite des Substrats, wobei dieses Modul auch mit einem elektronischen Chip (120) versehen ist, der mit mindestens bestimmten Kontakten (102) und mit mindestens zwei Leiterbahnen (414) verbunden ist, die einem Antennenanschluss gewidmet sind,
- die Herstellung einer Antenne (214) mit zwei Enden (216, 218),
- das Laminieren der Antenne (214) zwischen Kunststoffschichten (205, 220) und
- Einsetzen des Moduls (400) in einen Hohlraum (410), der in mindestens einigen der Kunststoffschichten (220) ausgebildet ist,
- das Verbinden mithilfe eines Lötmaterials, das auf einen Verbindungsabschnitt (319) jedes der Enden (216, 218) der Antenne (214) mit einer Fläche (416) des Moduls (400) aufgebracht und erhitzt wird, sobald das Modul (400) in dem Hohlraum (410) angeordnet ist,
**dadurch gekennzeichnet, dass** die Verbindungsanschlußflächen (416) jeweils auf einem Bereich (417) ausgebildet sind, der eine Fläche abdeckt, die kleiner ist als die eines Anschlussabschnitts (319), der in einer leitfähigen Schicht ausgebildet und mit Lötmaterial (350) bedeckt ist.

2. Verfahren nach Anspruch 1, wobei das Lötmaterial (350) aus einem Material mit einer Schmelztemperatur zwischen 120°C und 230°C und besonders bevorzugt zwischen 130°C und 150°C besteht.

3. Verfahren nach einem der vorhergehenden Ansprüche, bei dem mindestens eine der Verbindungsanschlußflächen (416) mit mindestens einem Stab (418) hergestellt wird, der sich in Längsrichtung in einer Richtung (L) über eine Länge zwischen 1 und 7 mm erstreckt.

4. Verfahren nach einem der vorhergehenden Ansprüche, bei dem man mindestens eine der Verbindungsanschlußflächen (416) mit mindestens einem Stab (418) herstellt, dessen Breite zwischen 50 und 300 µm liegt.

5. Verfahren nach einem der vorhergehenden Ansprüche, bei dem mindestens eines der Verbindungsanschlußflächen (416) mit mindestens einem Stab (418) hergestellt wird, der sich in Längsrichtung in einer Richtung (L) erstreckt, die im Wesentlichen senkrecht zur Länge des Moduls (400) verläuft.

6. Verfahren nach einem der vorhergehenden Ansprüche, bei dem mindestens eine der Verbindungsflächen (416) hergestellt wird, die mindestens einen Stab (418) umfasst, dessen Enden zum Inneren des Moduls (400) hin umgebogen sind.

7. Verfahren nach einem der vorhergehenden Ansprüche, bei dem mindestens eines der der Verbindungsanschlußflächen (416) mit mindestens zwei Stäben (418) hergestellt wird, die an ihren Längsenden elektrisch verbunden sind.

8. Verfahren nach einem der vorhergehenden Ansprüche, bei dem man eine Verbindungseinheit (300) herstellt und die Enden der Antenne (214) einerseits mit ersten Abschnitten (317) der Verbindungseinheit (300) verbindet und andererseits einen Tropfen Lötmaterial (350) auf zweite Abschnitte (319) der Verbindungseinheit (300) aufträgt, um eine Lötverbindung mit jedem der Verbindungsanschlußflächen (416) herzustellen.

9. Smartcard bestehend aus :
- eine Antenne (214) mit zwei Enden (216, 218),
- Kunststoffschichten (205, 220), zwischen denen die Antenne (214) angeordnet ist, und
- ein Modul (400), das ein Substrat (450) mit einer ersten und einer zweiten Hauptseite umfasst, wobei auf der ersten Seite des Substrats Kontakte (412) und auf der zweiten Seite des Substrats Leiterbahnen (414) mit Anschlussflecken (416) vorhanden sind, wobei dieses Modul auch mit einem elektronischen Chip versehen ist, der mit mindestens einigen Kontakten (412) und mindestens zwei Leiterbahnen (414) verbunden ist, die einer Antennenverbindung gewidmet sind, wobei das Modul (400) in einem Hohlraum (410) angeordnet ist, der in mindestens einigen der Kunststoffschichten (220) ausgebildet ist,
- einen Verbindungsabschnitt (319), der mit jedem der Enden (216, 218) der Antenne (214) verbunden ist und Lötmaterial aufweist, das an eine Verbindungsanschlußflächen (416) des Moduls (400) gelötet ist,
**dadurch gekennzeichnet, dass** die Verbindungsanschlußflächen (416) jeweils einen Bereich (417) mit einer Fläche bedecken, die kleiner ist als die eines Verbindungsabschnitts (319), der in einer leitfähigen Schicht ausgebildet und mit dem Lötmaterial (350) bedeckt ist.

10. Smartcard nach Anspruch 9, wobei das Lötmaterial (350) aus einem Material mit einer Schmelztemperatur zwischen 120°C und 230°C und besonders bevorzugt zwischen 130°C und 150°C besteht.

11. Chipkartenmodul zur Herstellung einer Chipkarte nach einem der Ansprüche 9 und 10, wobei dieses Modul ein Substrat (450) mit einer ersten und einer zweiten Hauptseite umfasst, wobei auf der ersten Seite des Substrats Kontakte (412) und auf der zweiten Seite des Substrats Leiterbahnen (414) mit Verbindungsanschlußflächen (416) vorhanden sind, wobei dieses Modul dazu bestimmt ist, mit einem elektronischen Chip versehen zu werden, der mit mindestens einigen Kontakten (412) und mindestens zwei Leiterbahnen (414) verbunden ist, die einer Antennenverbindung gewidmet sind, wobei dieses Modul auch dazu bestimmt ist, mit einem Verbindungsabschnitt (319) verbunden zu werden, der in einer leitenden Schicht ausgebildet ist und mit jedem der Enden (216, 218) einer Antenne (214) verbunden ist und Lötmaterial enthält,
wobei die Verbindungsflecken (416) jeweils einen Bereich (417) mit einer Fläche bedecken, die kleiner ist als die eines Verbindungsabschnitts (319), der mit dem Lötmaterial (350) bedeckt ist, und mindestens einer der Verbindungsanschlußflächen (416) mindestens einen Stab (418) aufweist, der sich in Längsrichtung in einer Richtung (L) über eine Länge von 1 bis 7 mm erstreckt und eine Breite von 50 bis 300 µm hat.

12. Smartcard-Modul nach Anspruch 11, wobei das Lötmaterial (350) aus einem Material mit einer Schmelztemperatur zwischen 120°C und 230°C und besonders bevorzugt zwischen 130°C und 150°C besteht.

13. Chipkartenmodul nach einem der Ansprüche 11 oder 12, bei dem ein Fläche (416) mindestens zwei Stäbe (418) umfasst, deren Längsenden gebogen und elektrisch verbunden sind.

## Claims

1. A method of manufacturing a chip card, comprising:
- production of a smart card (1) module (400) comprising a substrate (450) having first and second main faces, with contacts (412) on the first face of the substrate, and conductive tracks (414) comprising connection pads (416) on the second face of the substrate, this module also being provided with an electronic chip (120) connected to at least some contacts (102) and to at least two conductive tracks (414) dedicated to an antenna connection,
- making an antenna (214) with two ends (216, 218),
- laminating the antenna (214) between layers of plastic (205, 220), and
- positioning the module (400) in a cavity (410) formed in at least some of the plastic layers (220),
- connection by means of a solder material deposited on a connection portion (319) of each of the ends (216, 218) of the antenna (214) with a connection pad (416) of the module (400), and heated, once the module (400) is in place in the cavity (410),
**characterised by** the fact that the connection pads (416) are each produced on a zone (417) covering a surface area smaller than that of a connection portion (319), formed in a conductive layer and covered with soldering material (350).

2. A process as claimed in claim 1, wherein the solder material (350) consists of a material having a melting temperature of between 120°C and 230°C, and more preferably between 130°C and 150°C.

3. Method according to one of the preceding claims, in which at least one of the connection pads (416) comprising at least one bar (418) extending longitudinally in a direction (L) over a length of between 1 and 7 mm is produced.

4. Method according to one of the preceding claims, in which at least one of the connection pads (416) is produced comprising at least one bar (418), the width of which is between 50 and 300 µm.

5. Method according to one of the preceding claims, in which at least one of the connection pads (416) comprising at least one bar (418) extending longitudinally in a direction (L) essentially perpendicular to the length of the module (400) is produced.

6. Method according to one of the preceding claims, in which at least one of the connection pads (416) is produced comprising at least one bar (418), the ends of which are bent towards the inside of the module (400).

7. Method according to one of the preceding claims, in which at least one of the connection pads (416) comprising at least two bars (418) electrically connected by their longitudinal ends is produced.

8. Method according to one of the preceding claims, in which a connection unit (300) is produced and the ends of the antenna (214) are connected on the one hand to first portions (317) of the connection unit (300) and on the other hand a drop of soldering material (350) is deposited on second portions (319) of the connection unit (300) in order to produce a solder joint with each of the connection pads (416).

9. Smart card including :
- an antenna (214) with two ends (216, 218),
- plastic layers (205, 220) between which the antenna (214) is placed, and
- a module (400) comprising a substrate (450) having first and second main faces, with contacts (412) on the first face of the substrate and conductive tracks (414) comprising connection pads (416) on the second face of the substrate, this module also being provided with an electronic chip connected to at least some contacts (412) and to at least two conductive tracks (414) dedicated to an antenna connection, the module (400) being placed in a cavity (410) formed in at least some of the plastic material layers (220),
- a connection portion (319), connected to each of the ends (216, 218) of the antenna (214) and comprising solder material soldered to a connection pad (416) of the module (400),
**characterised in that** the connection pads (416) each cover a zone (417) having a surface area smaller than that of a connection portion (319), formed in a conductive layer and covered with the solder material (350).

10. A smart card according to claim 9, in which the solder material (350) consists of a material having a melting temperature of between 120°C and 230°C, and more preferably between 130°C and 150°C.

11. Smart card module for producing a smart card according to one of claims 9 and 10, this module comprising a substrate (450) having a first and a second main face, with, on the first face of the substrate, contacts (412), and, on the second face of the substrate, conductive tracks (414) comprising connection pads (416), this module being intended to be provided with an electronic chip connected to at least some contacts (412) and to at least two conductive tracks (414) dedicated to an antenna connection, this module also being intended to be connected to a connection portion (319), formed in a conductive layer and connected to each of the ends (216, 218) of an antenna (214) and comprising soldering material,
in which the connection pads (416) each cover an area (417) having a surface smaller than that of a connection portion (319) covered with the solder material (350) and at least one of the connection pads (416) comprises at least one bar (418) extending longitudinally in a direction (L) over a length of between 1 and 7 mm and whose width is between 50 and 300 µm.

12. A smart card module according to claim 11, in which the solder material (350) consists of a material having a melting temperature of between 120°C and 230°C, and more preferably between 130°C and 150°C.

13. A smart card module according to one of claims 11 or 12, in which a connection pad (416) comprises at least two bars (418), the longitudinal ends of which are bent and electrically connected.
